Europäisches Patentamt

European Patent Office

Office européen des brevets

(19)

(11) Veröffentlichungsnummer: **0 117 995**
**B1**

# (12) EUROPÄISCHE PATENTSCHRIFT

(45) Veröffentlichungstag der Patentschrift:
22.04.87

(51) Int. Cl.⁴: **H 03 K 17/96, H 01 B 1/20**

(21) Anmeldenummer: **84100670.3**

(22) Anmeldetag: **23.01.84**

(54) Abdeckung für Installationsgeräte und Verfahren zu ihrer Herstellung.

(30) Priorität: **03.02.83 DE 3303683**

(43) Veröffentlichungstag der Anmeldung:
**12.09.84 Patentblatt 84/37**

(45) Bekanntmachung des Hinweises auf die Patenterteilung:
**22.04.87 Patentblatt 87/17**

(84) Benannte Vertragsstaaten:
**DE SE**

(56) Entgegenhaltungen:
**DE - A - 2 845 830**

(73) Patentinhaber: **Siemens Aktiengesellschaft Berlin und München, Wittelsbacherplatz 2, D-8000 München 2 (DE)**

(72) Erfinder: **Zirkl, Siegmar, Dipl.-Ing., Klenze-Strasse 4, D-8400 Regensburg (DE)**

## Beschreibung

Die Erfindung bezieht sich auf eine Abdeckung für Installationsgeräte, die mittels eines Sensorkörpers mit Berührungsfläche durch Berühren und hierbei erzeugte galvanische oder kapazitive Ableitströme geschaltet werden. Solche Installationsgeräte mit Sensorschaltung sind bekannt (DE-OS 2 845 830).

Es sind Installationsgeräte mit Abdeckungen aus echtem Holz auf dem Markt. Die Handbetätigungsorgane von Schaltern oder Tastern weisen entsprechend eine Holzplatte auf, die auf einem Trägerkörper, beispielsweise aus Kunststoff, aufgeklebt ist. Die isolierende Wirkung von Holz ist hierbei günstig. Nachteilig ist diese isolierende Wirkung jedoch bei der Entwicklung von Installationsgeräten, die mittels eines Sensorkörpers mit Berührungsfläche zu schalten sind. Aus ästhetischen Gründen ist es nämlich wünschenswert, auch die Berührungsfläche selbst aus Holz auszubilden.

Der Erfindung liegt die Aufgabe zugrunde, eine Abdeckung aus echtem Holz für Installationsgeräte zu entwickeln, die mittels eines Sensorkörpers mit Berührungsfläche zu schalten sind und bei denen auch die Berührungsfläche selbst aus Holz besteht.

Die Lösung der geschilderten Aufgabe besteht nach der Erfindung darin, dass der Sensorkörper der Abdeckung aus Holz besteht, in dem nadeldünne elektrisch leitfähige Kanäle ausgebildet sind. Die Feinheit dieser Kanäle hängt im wesentlichen von den ästhetischen Bedürfnissen ab.

Solche Kanäle können in einfacher Weise so ausgebildet sein, dass der Sensorkörper aus Holz mit nadeldünnen Ausnehmungen versehen ist, die durch eine elektrisch leitfähige Masse ausgefüllt sind. Es ist in der Praxis dann günstig, den Sensorkörper aus Holz etwa 1 mm dünn auszubilden und mit ein bis drei Ausnehmungen pro mm² zu versehen.

Für Schalter, die mit galvanischen Ableitströmen arbeiten, können die Ausnehmungen als Durchbrüche ausgebildet sein. Bei kapazitiven Ableitströmen genügen Sacklöcher, die zum Gerätesockel hin offen sind.

Es ist fertigungstechnisch günstig, die Ausnehmungen konisch auszubilden, wobei deren Spitze zur Berührungsfläche des Sensorkörpers orientiert ist.

Eine brauchbare elektrisch leitfähige Masse ist Graphitemulsion. Die elektrisch leitfähige Masse kann jedoch auch aus Bronzeemulsion bestehen.

Als nadeldünne Kanäle können auch die natürlichen Holzkapillaren des Sensorkörpers durch elektrisch leitfähige Masse ausgefüllt werden. Dies kann durch eine geeignete chemische Behandlung an sich bekannter Art erreicht werden.

Die Abdeckung kann folgendermassen aufgebaut sein:

Der Sensorkörper ist auf seiner Rückseite mit einem Leitlack versehen, an dem ein Plättchen aus elektrisch leitendem Werkstoff anliegt. Hieran liegt eine Tragplatte mit einem Schnapphals an, der von einer Kontakthülse bis zum Plättchen durchdringbar ist, durch die zum Sockel eines Sensorschalters die elektrische Kontaktgabe herzustellen ist. Insbesondere kann das Plättchen als Bronzefederscheibe ausgebildet sein.

Um eine solche Abdeckung herzustellen kann man folgendermassen vorgehen:

Ein Holzstück in der Form des Sensorkörpers wird vertikal zu seiner Erstreckungsebene mit nadeldünnen Durchbrüchen versehen. Hierauf wird der Rohling insbesondere auf seiner Oberseite farblich gebeizt und nach dem Trocknen auf seiner Unterseite mit Leitlack versehen. Diesen Leitlack kann man infolge der Abstimmung seiner Konsistenz und Zähigkeit und der Grösse und der Form der Durchbrüche, gegebenenfalls unter Anwendung von Druckluft auf der Unterseite des Rohlings, bis zur Oberseite aufsteigen lassen. Hierauf kann man die Oberseite nach dem Eintrocknen dünn mit Schutzlack, z.B. Kunstharzlack, überziehen und danach schleifen, so dass der Leitlack in den Durchbrüchen offen zutage tritt.

Ein anderes Verfahren zum Herstellen einer Abdeckung mit Sensorkörper besteht darin,

– dass ein Holzstück in der Form des Sensorkörpers auf seiner Oberfläche farblich gebeizt und dann lackiert wird und vor dem Austrocknen vertikal zu seiner Erstreckungsebene mit nadeldünnen Durchbrüchen versehen wird.

– Hierauf kann der Rohling auf seiner Unterseite mit Leitlack versehen werden, den man infolge der Abstimmung seiner Konsistenz und Zähigkeit und der Grösse der Durchbrüche, gegebenenfalls unter Anwenden von Druckluft auf der Unterseite des Rohlings, bis zur Oberseite aufsteigen lässt.

– Hierauf kann die Oberseite nach dem Austrocknen des Lacks geschliffen werden.

Die Erfindung soll nun anhand von in der Zeichnung grob schematisch wiedergegebenen Ausführungsbeispielen näher erläutert werden:

In Fig. 1 ist in Explosionsdarstellung ein Sensorkörper der Abdeckung zusammen mit zum Gerätesockel kontaktgebenden Bauteilen wiedergegeben.

In Fig. 2 ist ein Längsschnitt durch den Sensorkörper nach Fig. 1 in abgebrochener Darstellung wiedergegeben.

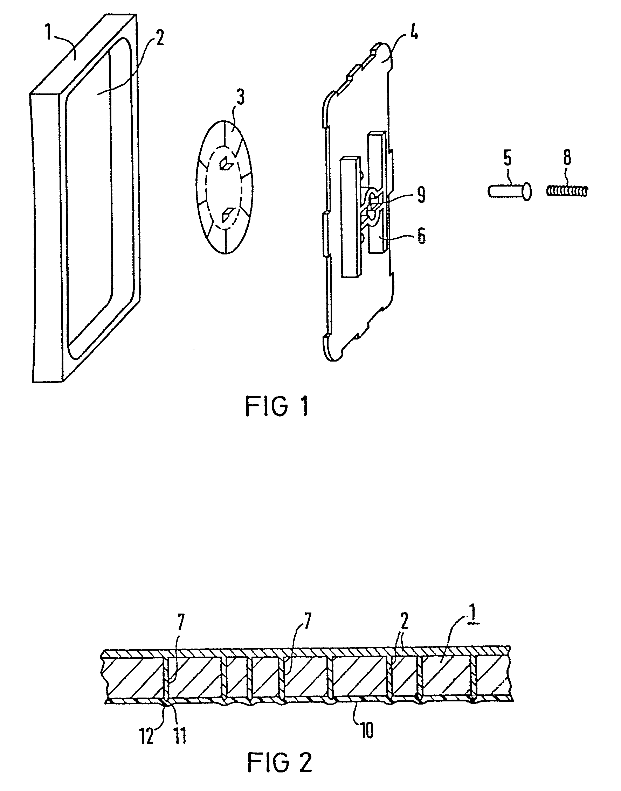

Aus einer Abdeckung für Installationsgeräte ist in Fig. 1 der Sensorkörper 1 mit einer in der Zeichnung unten liegenden Berührungsfläche aus Holz wiedergegeben. Der Sensorkörper 1 aus Holz ist von nadeldünnen elektrisch leitfähigen Kanälen 7 durchsetzt, wie sie aus Fig. 2 zu ersehen sind. Diese Kanäle können Ausnehmungen oder Durchbrüche sein, die durch eine elektrisch leitfähige Masse 2 ausgefüllt sind. Diese Masse kann ein Leitlack auf der Basis einer Graphitemulsion sein. Im Bereich der nadeldünnen Kanäle 7 im Sensorkörper 1 liegt ein Plättchen

- im Ausführungsbeispiel nach Fig. 1 eine elastische Bronzefederscheibe 3 – an, die am Innenrand mit dem Sensorkörper 1 verklebt werden kann. Die Bronzefederscheibe 3 vermittelt elektrischen Kontakt zu einer Tragplatte 4 mit Verstärkungsrippen 6, die aus Kunststoff gefertigt sein kann. Den elektrischen Kontakt zu einem nicht wiedergegebenen Sockel eines Installationsgerätes vermittelt eine Hülse 5 aus elektrisch leitfähigem Material, die von einer Feder 8 durch einen Durchbruch 9 in der Tragplatte 4 gegen die Bronzescheibe 3 gedrückt wird.

Die Tragplatte 4 kann durch einen an sich bekannten Schnappmechanismus auf einem Halsstück des Sockels des Installationsgerätes gehalten werden, wie es beispielsweise nach der DE-OS 2 845 830 realisiert ist.

Die Bronzescheibe 3 kann radiale Einschnitte aufweisen, wobei die Sektoren etwas aufgebogen werden, um die Bronzescheibe 3 gegen die Innenseite des Sensorkörpers 1 unter Vorspannung anfedern zu lassen. Um die zentrale Lage der Scheibe sicherzustellen, können zwei Blechnasen aufgebogen sein, wie es in Fig. 1 veranschaulicht ist. Diese Nasen können in zwei vorgesehene Öffnungen der Tragplatte 4 eingreifen.

Auf der Berührungsfläche des Sensorköpers 1 kann das zuvor gebeizte Holz durch einen Schutzlack 10 abgedeckt werden. In Fig. 2 ist das vor den Abschlussarbeiten veranschaulicht. Dort, wo die leitfähige Masse 2 durch die nadeldünnen Kanäle 7 in Spitzen 11 hervortritt, bildet der Schutzlack 10 noppenförmige Erhebungen 12. Schleift man die Oberfläche des Lacks 10 ab, kann die leitfähige Masse 2 an der Oberfläche zutage treten. Der elektrische Kontakt für eine galvanische Ableitung ist dann sichergestellt. Für eine kapazitive Ableitung ist es nicht erforderlich, dass die leitfähige Masse 2 auf der Oberfläche zutage tritt.

Die Kanäle 7 im Sensorkörper 1 können mechanisch durch ein Nadelkissen, durch Laserstrahlen oder durch elektrische Entladung im Holz ausgebildet werden. In der Praxis ist es günstig, den Sensorkörper aus Holz etwa 1 mm dünn auszubilden und mit ein bis drei Kanälen pro mm² zu versehen.

Nach einem ersten Verfahren zum Herstellen einer Abdeckung mit Sensorkörper kann man folgendermassen vorgehen:

- Ein Holzstück in der Form des Sensorkörpers 1 wird vertikal zu seiner Erstreckungsebene mit nadeldünnen Durchbrüchen (Kanäle 7) versehen.
- Hierauf wird der Rohling insbesondere auf seiner Oberseite farblich gebeizt und nach dem Trocknen auf seiner Unterseite mit Leitlack versehen. Infolge der Abstimmung seiner Konsistenz und Zähigkeit und der Grösse und Form der Durchbrüche kann man ihn bis zur Oberseite des Sensorkörpers 1 aufsteigen lassen. Gegebenenfalls kann man auf die Unterseite Druckluft blasen, um das Hochsteigen zu fördern.
- Hierauf kann man die Oberseite nach dem Eintrocknen der leitfähigen Masse, bzw. des Leitlacks, dünn mit einem Schutzlack, beispielsweise einem Kunstharzlack, überziehen und danach schleifen, bis der Leitlack in den Kanälen zutage tritt.

Man kann auch so vorgehen,
- dass ein Holzstück in der Form des Sensorkörpers 1 auf seiner Oberfläche farblich gebeizt und dann lackiert wird und vor dem Austrocknen vertikal zu seiner Erstreckungsebene mit nadeldünnen Durchbrüchen – Kanälen 7 – versehen wird. Der Schutzlack auf der Oberfläche ist dann noch elastisch und bricht beim Ausbilden der Kanäle an der Oberfläche nicht aus.
- Hierauf kann der Rohling auf seiner Unterseite mit Leitlack – Masse 2 – versehen werden, den man infolge der Abstimmung seiner Konsistenz und Zähigkeit und der Grösse der Durchbrüche bis zur Oberseite aufsteigen lässt. Das kann gegebenenfalls durch Anwenden von Druckluft auf der Unterseite des Rohlings gefördert werden.
- Nachdem der Leitlack auf der Oberseite zutage getreten ist, kann die Oberseite nach dem Austrocknen des Leitlacks gegebenenfalls geschliffen werden. Dies ist bei dieser Verfahrensweise allein an ästhetischen Gesichtspunkten zu orientieren, da die Kanäle bzw. Durchbrüche durch den Schutzlack hindurch eingebracht wurden, so dass die elektrische Verbindung auch ohne Abschleifen der Oberfläche zustande kommt.

## Patentansprüche

1. Abdeckung für Installationsgeräte, die mittels eines Sensorkörpers (1) mit Berührungsfläche durch Berühren und hierbei erzeugte galvanische oder kapazitive Ableitströme geschaltet werden, dadurch gekennzeichnet, dass der Sensorkörper (1) der Abdeckung aus Holz besteht, in dem nadeldünne elektrisch leitfähige Kanäle (7) ausgebildet sind.

2. Abdeckung nach Anspruch 1, dadurch gekennzeichnet, dass der Sensorkörper aus Holz mit nadeldünnen Ausnehmungen versehen ist, die durch eine elektrisch leitfähige Masse (2) ausgefüllt sind.

3. Abdeckung nach Anspruch 2, dadurch gekennzeichnet, dass der Sensorkörper (1) aus Holz etwa 1 mm dünn ausgebildet und mit ein bis drei Ausnehmungen pro mm² versehen ist.

4. Abdeckung nach Anspruch 3, dadurch gekennzeichnet, dass für Schalter, die mit galvanischen Ableitströmen arbeiten, die Ausnehmungen als Durchbrüche ausgebildet sind.

5. Abdeckung nach einem der Ansprüche 2 bis 4, dadurch gekennzeichnet, dass die Ausnehmungen konisch ausgebildet sind, wobei deren Spitze zur Berührungsfläche orientiert ist.

6. Abdeckung nach einem der Ansprüche 2 bis 5, dadurch gekennzeichnet, dass die elektrisch leitfähige Masse (2) aus Graphitemulsion besteht.

7. Abdeckung nach einem der Ansprüche 2 bis 5, dadurch gekennzeichnet, dass die elektrisch leitfähige Masse (2) aus Bronzeemulsion besteht.

8. Abdeckung nach Anspruch 1 und 2, dadurch gekennzeichnet, dass als nadeldünne Kanäle (7) die natürlichen Holzkapillaren des Sensorkörpers (1) dienen, die durch elektrisch leitfähige Masse ausgefüllt sind.

9. Abdeckung nach einem der Ansprüche 2 bis 8, dadurch gekennzeichnet, dass der Sensorkörper (1) auf seiner Rückseite mit einem Leitlack versehen ist, an dem den Plättchen (3) aus elektrisch leitendem Werkstoff anliegt und hieran eine Tragplatte (4) mit einem Schnapphals, der von einer Kontakthülse (5) bis zum Plättchen (3) durchdringbar ist, durch die zum Sockel eines Sensorschalters die elektrische Kontaktgabe herzustellen ist.

10. Abdeckung nach Anspruch 9, dadurch gekennzeichnet, dass das Plättchen (3) als Bronzescheibe ausgebildet ist.

11. Verfahren zum Herstellen einer Abdeckung mit Sensorkörper nach Anspruch 9, dadurch gekennzeichnet,

– dass ein Holzstück in der Form des Sensorkörpers (1) vertikal zu seiner Erstreckungsebene mit nadeldünnen Durchbrüchen (Kanäle 7) versehen wird,

– hierauf der Rohling insbesondere auf seiner Oberseite farblich gebeizt und nach dem Trocknen auf seiner Unterseite mit Leitlack (leitfähige Masse 2) versehen wird, den man infolge der Abstimmung seiner Konsistenz und Zähigkeit und der Grösse und Form der Durchbrüche (Kanäle 7), gegebenenfalls unter Anwendung von Druckluft auf der Unterseite des Rohlings, bis zur Oberseite aufsteigen lässt,

– worauf die Oberseite nach dem Eintrocknen dünn mit Schutzlack (10) überzogen und danach geschliffen wird, so dass der Leitlack in den Durchbrüchen (Kanälen 7) zutage tritt.

12. Verfahren zum Herstellen einer Abdeckung mit Sensorkörper nach Anspruch 9, dadurch gekennzeichnet, dass ein Holzstück in der Form des Sensorkörpers (1) auf seiner Oberfläche farblich gebeizt und dann lackiert wird und vor dem Austrocknen vertikal zu seiner Erstreckungsebene mit nadeldünnen Durchbrüchen (Kanälen 7) versehen wird,

– hierauf der Rohling mit seiner Unterseite mit Leitlack (Masse 2) versehen wird, den man infolge der Abstimmung seiner Konsistenz und Zähigkeit und der Grösse und Form der Durchbrüche, gegebenenfalls unter Anwenden von Druckluft auf der Unterseite des Rohlings, bis zur Oberseite aufsteigen und zutage treten lässt,

– worauf die Oberseite nach dem Austrocknen des Lacks gegebenenfalls geschliffen wird.

**Claims**

1. A cover for installation devices which are switched by galvanic or capacitive leakage currents produced by contacting a sensor body (1) having a contact surface, characterised in that the sensor body (1) of the cover consists of wood, wherein needle-fine electrically conductive channels (7) are formed.

2. A cover as claimed in Claim 1, characterised in that the wooden sensor body is provided with needle-fine recesses which are filled with an electrically conductive compound (2).

3. A cover as claimed in Claim 2, characterised in that the wooden sensor body (1) is approximately 1 mm thick and provided with one to three recesses per square millimetre.

4. A cover as claimed in Claim 3, characterised in that for switches which operate by means of galvanic leakage currents the recesses are designed as penetrating apertures.

5. A cover as claimed in one of Claims 2 to 4, characterised in that the recesses are conical having their apex oriented towards the contact surface.

6. A cover as claimed in one of Claims 2 to 5, characterised in that the electrically conductive compound (2) consists of graphite emulsion.

7. A cover as claimed in one of Claims 2 to 5, characterised in that the electrically conductive compound (2) consists of bronze emulsion.

8. A cover as claimed in Claim 1 and 2, characterised in that the natural wood capillaries of the sensor body (1) which are filled with the electrically conductive compound, serve as needle-fine channels (7).

9. A cover as claimed in one of Claims 2 to 8, characterised in that at its rear the sensor body (1) is provided with a conducting lacquer, upon which a plate (3) of an electrically conductive material abuts and a supporting plate (4) having a snap neck, through which a contact sleeve (5) can penetrate to the plate (3), by means of which contact sleeve electrical contact is to be established to the base of a sensor switch.

10. A cover as claimed in Claim 9, characterised in that the plate (3) is a bronze disc.

11. A process for the production of a cover having a sensor body as claimed in Claim 9, characterised in

– that a piece of wood in the form of the sensor body (1) is provided with needle-fine openings (channels 7) vertically to its plane of extension,

– the unfinished piece is subsequently stained with colour in particular on its top side and following the drying process is provided with conducting lacquer (conductive compound 2) on its underside, which lacquer as a result of the adjustement of its consistency and viscosity and the size and shape of the openings (channels 7), is allowed to rise to the top side, possibly by applying compressed air on the underside of the unfinished piece,

– whereupon after drying, the upper surface is thinly coated with protective lacquer (10) and subsequently polished, so that the conducting lacquer appears in the openings (channels 7).

12. A process for the production of a cover having a sensor body as claimed in Claim 9, characterised in that a piece of wood in the form of the sensor body (1) is stained with colour on its top side and subsequently lacquered and prior to the drying process provided with needle-fine openings (channels 7) vertically to its plane of extension,

– the unfinished piece is subsequently provided with conducting lacquer (compound 2) on its underside, which lacquer as a result of the adjustment of its consistency and viscosity and the size and shape of the openings is allowed to rise to the top side and to appear, possibly by applying compressed air on the underside of the unfinished piece,

– whereupon the top side is possibly polished following the drying process of the lacquer.

## Revendications

1. Couvercle pour des appareils d'installation électriques, destinés à être posés et mis en circuit, au moyen d'un détecteur (1) à surface de contact, par attouchement et par des courants de fuite galvaniques ou capacitifs ainsi produits, caractérisé en ce que le détecteur (1) du couvercle est en bois dans lequel ont été ménagés des canaux (7) conducteurs de l'électricité de la finesse d'une aiguille.

2. Couvercle suivant la revendication 1, caractérisé en ce que le détecteur en bois est muni d'évidements de la finesse d'une aiguille, qui sont emplis d'une composition (2) conductrice de l'électricité.

3. Couvercle suivant la revendication 2, caractérisé en ce que le détecteur (1) en bois a, à peu près, 1 mm d'épaisseur et est muni de un à trois évidements par mm$^2$.

4. Couvercle suivant la revendication 3, caractérisé en ce que, pour des interrupteurs qui fonctionnent avec des courants de fuite galvaniques, les évidements sont constitués en perçages traversants.

5. Couvercle suivant l'une des revendications 2 à 4, caractérisé en ce que les évidements sont coniques à sommets tournés vers la surface de contact.

6. Couvercle suivant l'une des revendications 2 à 5, caractérisé en ce que la composition (2) conductrice de l'électricité est constituée d'une émulsion de graphite.

7. Couvercle suivant l'une des revendications 2 à 5, caractérisé en ce que la composition (2) conductrice de l'électricité est constituée d'une émulsion de bronze.

8. Couvercle suivant la revendication 1 ou 2, caractérisé en ce que sont utilisés, comme canaux (7) d'une aiguille, les vaisseaux capillaires naturels du bois du détecteur (1) qui sont emplis de la composition conductrice de l'électricité.

9. Couvercle suivant l'une des revendications 2 à 8, caractérisé en ce que la face arrière du détecteur (1) est munie d'un vernis conducteur sur lequel s'applique une plaquette (3) en un matériau conducteur de l'électricité, et sur celle-ci une platine d'appui (4) ayant un collet à déclic qui peut être traversé par un tenon de contact (5) allant jusqu'à la plaquette (3), tenon par lequel est réalisé le contact électrique avec la douille d'un interrupteur à attouchement.

10. Couvercle suivant la revendication 9, caractérisé en ce que la plaquette (3) est une rondelle en bronze.

11. Procédé de fabrication d'un couvercle à détecteur suivant la revendication 9, caractérisé en ce qu'il consiste:

– à ménager, dans une pièce en bois ayant la forme du détecteur (1), des perçages traversants (canaux 7) de la finesse d'une aiguille, verticalement par rapport au plan suivant lequel elle s'étend,

– puis à décaper chromatiquement l'ébauche, notamment la face supérieure de celle-ci, et, après le séchage, à en munir la face inférieure d'un vernis conducteur (composition conductrice 2) que l'on fait monter jusqu'à la face supérieure, en raison de l'ajustement de sa consistance et de sa viscosité, et de la dimension et de la forme des perçages traversants (canaux 7), le cas échéant en utilisant de l'air comprimé sur la face inférieure de l'ébauche,

– puis à revêtir la face supérieure, après le séchage, d'un mince vernis de protection (10) et, ensuite, à la poncer de manière à mettre nu le vernis conducteur dans les perçages traversants (canaux 7).

12. Procédé de fabrication d'un couvercle à détecteur suivant la revendication 9, caractérisé en ce qu'il consiste à décaper chromatiquement, sur sa surface une pièce en bois ayant la forme du détecteur (1), puis à la vernir et, avant le séchage, à y ménager, verticalement par rapport au plan dans laquelle elle s'étand, des perçages traversants (canaux 7) de la finesse d'une aiguille,

– à munir ensuite la face inférieure de l'ébauche d'un vernis conducteur (composition 2), que l'on fait monter et affleurer jusqu'à la face supérieure en ajustant sa consistance et sa viscosité et la dimension et la forme des passages traversants, le cas échéant en utilisant de l'air comprimé sur la face inférieure de l'ébauche,

– puis à poncer, le cas échéant, la face supérieure après le séchage du vernis.

FIG 1

FIG 2